(19) **Europäisches Patentamt European Patent Office Office européen des brevets**

(11) **EP 2 862 036 B1**

(12) **FASCICULE DE BREVET EUROPEEN**

(45) Date de publication et mention de la délivrance du brevet:
**11.09.2019 Bulletin 2019/37**

(21) Numéro de dépôt: **13737333.8**

(22) Date de dépôt: **19.06.2013**

(51) Int Cl.:
*H03L 7/093* (2006.01)    *G06F 1/08* (2006.01)

(86) Numéro de dépôt international:
**PCT/FR2013/051433**

(87) Numéro de publication internationale:
**WO 2013/190236 (27.12.2013 Gazette 2013/52)**

(54) **DISPOSITIF D'ALIMENTATION D'UN CIRCUIT ÉLECTRONIQUE**

VORRICHTUNG ZUR VERSORGUNG EINES ELEKTRONISCHEN STROMKREISES

DEVICE FOR SUPPLYING AN ELECTRONIC CIRCUIT

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **19.06.2012 FR 1255707**

(43) Date de publication de la demande:
**22.04.2015 Bulletin 2015/17**

(73) Titulaire: **Commissariat à l'Énergie Atomique et aux Énergies Alternatives 75015 Paris (FR)**

(72) Inventeurs:
• **PUSCHINI PASCUAL, Diego 38240 Meylan (FR)**
• **LESECQ, Suzanne 38190 Froges (FR)**

(74) Mandataire: **Santarelli 49, avenue des Champs-Elysées 75008 Paris (FR)**

(56) Documents cités:
**EP-A2- 0 944 172    WO-A2-2005/060103
US-A- 5 257 294    US-A1- 2008 284 524
US-B1- 6 236 278**

**Description**

L'invention concerne un dispositif d'alimentation d'un circuit électronique avec application d'un signal d'horloge.

Lorsque l'on souhaite minimiser la consommation énergétique d'un circuit électronique numérique synchrone cadencé par un signal d'horloge, tout en garantissant ses performances, il est connu d'appliquer à ce circuit une fréquence d'horloge adaptée à une tension d'alimentation donnée. Par « circuit synchrone », on entend un « circuit cadencé par une horloge ».

Il a par ailleurs été proposé d'adapter la fréquence d'horloge en fonction des performances souhaitées pour le système, et de modifier également la tension d'alimentation, technique connue sous l'acronyme DVFS (pour « *Dynamic Voltage and Frequency Scaling »).*

Ces techniques sont en particulier appliquées dans le cas d'architectures Globalement Asynchrones Localement Synchrones (ou GALS pour « *Globally asynchronous Locally Synchronous* »), où le système concerné est découpé en différents îlots tension d'alimentation - fréquence (îlots couramment dénommés VFI pour « *Voltage Frequency Island* »). De telles architectures sont par exemple réalisées sous forme de systèmes sur puce (ou SoC pour « *System on Chip* »).

La tension d'alimentation variable à appliquer au circuit électronique est générée par un module dénommé « *actionneur de tension* », par exemple selon la technique dite de « *Vdd-hopping* », décrite dans l'article « A power supply selector for energy- and area-efficient local dynamic voltage scaling », de S. Miermont, P. Vivet et M. Renaudin, in Lecture Notes in Computer Science, Volume 4644, pages 556-565, 2007.

Le signal d'horloge de fréquence variable à appliquer au circuit électronique est quant à lui généré par un module dit « *actionneur de fréquence* » ; un tel actionneur de fréquence est par exemple réalisé sous forme d'une boucle à verrouillage de fréquence (ou FLL pour « *Frequency Locked-Loop* ») ou sous forme d'une boucle à verrouillage de phase (ou PLL pour « *Phase Locked-Loop »).*

De tels actionneurs de fréquence sont réalisés sous forme d'un système fonctionnant en boucle fermée qui inclut notamment un contrôleur influant sur la grandeur générée en fonction de l'erreur mesurée (différence entre la grandeur mesurée et la consigne) et d'une loi de commande.

Exemples d'actionneurs de fréquence sont décrits dans les documents US 5 257 294, EP 0 944 172, US 6 236 278 et WO 2005/060103.

L'invention propose un dispositif d'alimentation tel que défini par les revendications.

La réponse de l'actionneur de fréquence est ainsi différenciée en fonction du sens de variation de la consigne en fréquence.

D'autres caractéristiques et avantages de l'invention apparaîtront mieux à la lecture de la description qui suit, faite en référence aux dessins annexés dans lesquels :

- la figure 1 représente un contexte général dans laquelle peut être mise en oeuvre la présente invention ;
- la figure 2 représente les éléments principaux d'un actionneur de fréquence conformes aux enseignements de l'invention ;
- la figure 3A représente un premier exemple de réalisation du contrôleur de la figure 2 ;
- la figure 3B représente une variante de réalisation du premier exemple de réalisation ;
- la figure 4 représente un second exemple de réalisation du contrôleur de la figure 2 ;
- la figure 5 représente un troisième exemple de réalisation du contrôleur de la figure 2 ;
- la figure 6 représente un quatrième mode de réalisation de l'invention.

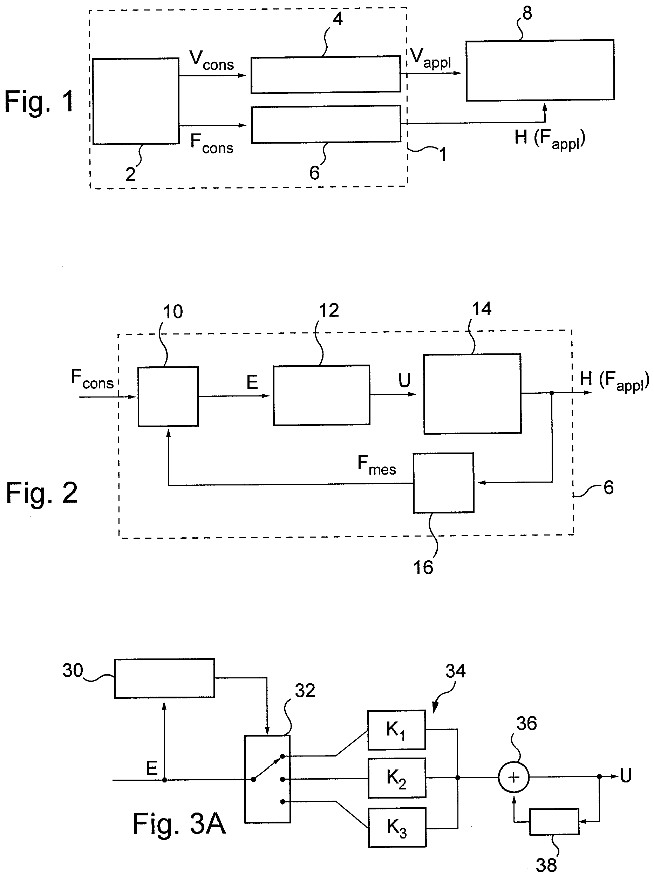

Comme visible en **figure 1,** un dispositif d'alimentation 1 d'un circuit électronique 8, par exemple un îlot tension-fréquence (ou VFI) d'une architecture GALS, comprend un module de commande 2 qui génère une consigne en tension $V_{cons}$ et une consigne en fréquence $F_{cons}$.

Ces consignes sont générées en fonction des performances souhaitées pour le circuit électronique 8, par exemple sur la base d'instructions reçues et d'une date limite pour leur exécution d'un module de coordination du fonctionnement de différents îlots (non représenté).

La consigne en tension $V_{cons}$ est appliquée à un actionneur de tension 4 qui génère, en fonction de la consigne en tension $V_{cons}$, une tension $V_{appl}$ appliquée au circuit électronique 8.

La consigne en fréquence $F_{cons}$ est appliquée à un actionneur de fréquence 6 qui génère un signal d'horloge H à une fréquence $F_{appl}$ déterminée sur la base de la consigne en fréquence $F_{cons}$ comme expliqué ci-après. Le signal d'horloge H est appliqué au circuit électronique 8.

Les consignes $V_{cons}$, $F_{cons}$ appliquées à un instant donné sont telles qu'elles permettent un fonctionnement sans faute du circuit électronique 8.

Ainsi, afin de passer d'un premier couple de valeurs (tension, fréquence)$_1$ à un second couple de valeurs (tension, fréquence)$_2$, les actions des actionneurs de tension et de fréquence doivent être synchronisées, notamment dans le cas où la tension et la fréquence sont modifiées dans un intervalle de temps déterminé.

Ces couples de valeurs peuvent être déterminés à l'avance pour un circuit donné, par exemple en fonction d'études préalables réalisées sur des circuits de ce type. En variante, ces valeurs peuvent être déterminées au cours d'une phase d'étalonnage au cours de laquelle on teste, pour chaque tension appliquée, le fonctionnement du circuit pour une pluralité de fréquences d'horloge envisagées, la fréquence la plus élevée assurant un fonctionnement sans faute étant retenue.

L'utilisation de consignes $V_{cons}$, $F_{cons}$ adaptées à un fonctionnement sans faute est également mise en oeuvre lors de modifications de ces consignes. Par exemple, on applique systématiquement, lors d'un changement ou saut de consigne en fréquence correspondant à une augmentation de fréquence, la tension adaptée à la fréquence la plus élevée rencontrée au cours du saut, puis on applique la nouvelle fréquence une fois le saut en tension effectué.

La réponse temporelle de la sortie d'un système classique à un changement de consigne n'est toutefois pas toujours adaptée aux différentes situations rencontrées en fonctionnement. Dans la suite, on entend par « réponse » la « réponse temporelle de la sortie d'un tel système ».

Ainsi par exemple, la réponse du système en boucle fermée dans son ensemble peut être influencée par des phénomènes tels que la variabilité du processus de fabrication ou des variations de température rencontrées.

Les contraintes à respecter par la fréquence générée peuvent par ailleurs différer en fonction des phases de fonctionnement du système : dans une phase de diminution de la fréquence (nouvelle consigne inférieure à la valeur antérieure), on peut accepter un dépassement (vers le bas) de la nouvelle consigne, tandis qu'un tel dépassement est inacceptable dans le cas d'une augmentation de la fréquence (nouvelle consigne supérieure à la consigne précédente) car elle pourrait entraîner des fautes de fonctionnement du fait de l'utilisation d'une fréquence d'horloge supérieure à celle prévue (et pour laquelle une tension adaptée est appliquée au circuit).

La **figure 2** représente un exemple de réalisation de l'actionneur de fréquence 6.

Comme déjà indiqué, l'actionneur de fréquence 6 génère un signal d'horloge H à une fréquence $F_{appl}$ sur la base d'une consigne en fréquence $F_{cons}$.

L'actionneur de fréquence 6 comprend un capteur 16 qui mesure la fréquence du signal d'horloge H et génère un signal représentatif de la fréquence mesurée $F_{mes}$. Dans le cas où l'information fournie par le capteur est numérique (c'est-à-dire un nombre), le capteur 16 est typiquement un compteur qui produit à sa sortie le nombre d'impulsions d'horloge mesurées au niveau du signal d'horloge H pendant une durée prédéterminée.

L'actionneur de fréquence 6 comprend également un soustracteur 10 qui détermine l'écart (c'est-à-dire la différence) entre la fréquence mesurée $F_{mes}$ et la consigne en fréquence $F_{cons}$ et génère un signal d'erreur E représentatif de l'écart calculé.

L'actionneur de fréquence 6 comprend un contrôleur 12 qui reçoit le signal d'erreur E et qui génère, sur la base de ce signal d'erreur E et en fonction d'une loi de commande, un signal de commande U du système 14 à contrôler, ici un oscillateur commandé numériquement (ou DCO pour « *Digitally Controlled Oscillator* »).

Comme évoqué précédemment, un écart ou dépassement de la nouvelle consigne est toléré lorsque celle-ci implique une diminution de la fréquence, mais un tel dépassement est inacceptable dans le cas d'une consigne impliquant une augmentation de la fréquence.

Le signal d'erreur E, notamment son signe, permet de déterminer si le dépassement concerné est une diminution ou une augmentation de la fréquence, et de prévoir des actions (régies par la loi de commande) pour éviter les éventuelles fautes de fonctionnement du circuit 8 dues classiquement au dépassement de la réponse de l'actionneur en fréquence 6 par rapport à la consigne. L'oscillateur commandé numériquement 14 comprend un convertisseur numérique-analogique et un oscillateur commandé en tension (ou VCO pour « *Voltage Controlled Oscillator* »). L'oscillateur commandé numériquement 14 génère ainsi un signal en sortie dont la fréquence est commandée par le signal de commande U : ce signal en sortie est le signal d'horloge H généré par l'actionneur de fréquence 6.

On utilisera plus loin la notation $K_{DCO}$ pour viser le gain de l'oscillateur 14.

On remarque que, dans le mode de réalisation décrit ici, les signaux représentatifs des différentes grandeurs $F_{mes}$, $F_{cons}$, E et U sont des mots numériques et que le contrôleur 12 notamment est ainsi un circuit numérique. En variante, on pourrait naturellement envisager que certains des signaux, et par conséquent éventuellement le contrôleur, soient réalisés sous forme analogique.

La **figure 3A** représente un premier exemple de réalisation du contrôleur 12 de la figure 2.

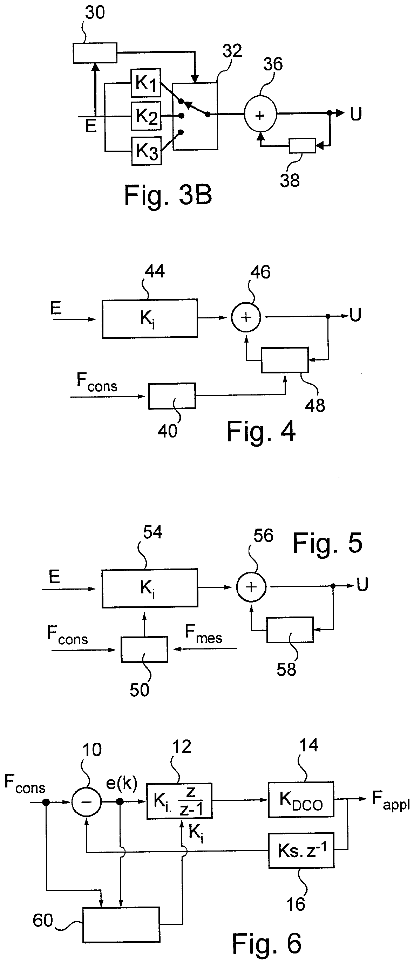

Dans ce mode de réalisation, le signal d'erreur E est appliqué sélectivement à un multiplicateur (par exemple celui de coefficient $K_1$ sur la figure 3) parmi une pluralité de multiplicateurs 34 (ici trois multiplicateurs de coefficients respectifs $K_1$, $K_2$, $K_3$) au moyen d'un sélecteur 32 commandé par un module d'adaptation 30. Une version dans laquelle le signal E serait appliqué à tous les multiplicateurs 34 et dans laquelle le sélecteur 32 commandé par un module d'adaptation 30 choisirait l'un des signaux en sortie des multiplicateurs 34 est également envisageable, voir la **figure 3B.**

De retour au mode de réalisation de la figure 3A, la sortie de chaque multiplicateur 34 est appliquée à un circuit additionneur 36 qui reçoit également en entrée son propre signal de sortie, retardé d'une durée déterminée par passage à travers une mémoire 38 prévue à cet effet.

Un tel contrôleur est de type intégrateur et génère en sortie à l'instant k un signal de commande U(k) = $K_i$.E(k)+U(k-1),
où U(k-1) est le signal de commande à l'instant (k-1) et $K_i$ est le coefficient du multiplicateur sélectionné.

On comprend que la valeur du paramètre $K_i$ influe sur le temps mis par le contrôleur 12 à générer un signal de commande U qui entraîne une fréquence du signal d'horloge H égale à la consigne $F_{cons}$ (c'est-à-dire un signal d'erreur E nul), puisque la valeur de $K_i$ détermine l'ampleur des variations du signal de commande U à chaque instant selon la formule qui vient d'être donnée.

Une valeur élevée du paramètre $K_i$ entraîne ainsi une variation rapide du signal de commande U, qui peut aller jusqu'à un dépassement de la consigne (même si le signal finira par converger vers la consigne puisque le dépassement de celle-ci entraîne un changement de signe du signal d'erreur E).

On remarque par ailleurs que le gain $K_{DCO}$ de l'oscillateur 14 est variable en fonction des conditions de fonctionnement (telle que la température) et peut donc avoir lui aussi un effet sur le temps de réponse du système bouclé (puisqu'un signal d'erreur E induit une modification $K_i$.E du signal de commande U et donc une modification $K_{DCO}.K_i$.E de la fréquence $F_{appl}$ du signal d'horloge H).

On propose que le module d'adaptation 30 commande le sélecteur 32 :

- de manière à appliquer le multiplicateur de coefficient $K_1$ au signal d'erreur E lorsque le changement de consigne $F_{cons}$ correspond à une réduction de la fréquence souhaitée ;
- de manière à appliquer le multiplicateur de coefficient $K_2$ (avec $K_2 < K_1$) lorsque le changement de consigne $F_{cons}$ correspond à une augmentation de la fréquence souhaitée et que la température ambiante T est supérieure (ou, selon une variante envisageable, inférieure) à un seuil $T_0$ prédéterminé ;
- de manière à appliquer au signal d'erreur E le multiplicateur de coefficient $K_3$ (avec $K_3 < K_2$) lorsque le changement de consigne $F_{cons}$ correspond à une augmentation de la fréquence souhaitée et que la température T est inférieure (ou, selon la variante qui vient d'être mentionnée, supérieure) au seuil prédéterminé $T_0$.

Les coefficients multiplicateurs $K_1$, $K_2$, $K_3$ sont par exemple prédéterminés en fonction des valeurs de fonctionnement prévues pour le système. Ces valeurs peuvent être issues de phase de calibration hors-ligne ou en cours de fonctionnement du système. L'utilisation de ces coefficients permet de faire varier le temps de réponse de l'actionneur de fréquence en fonction du signe de la variation de fréquence imposée par la nouvelle consigne par rapport à l'ancienne consigne.

Le module d'adaptation 30 détermine la commande à appliquer au sélecteur 32 par exemple en fonction du signal d'erreur E (qui indique si la prochaine modification de fréquence sera une réduction de fréquence ou une augmentation de fréquence) et d'une mesure de la température ambiante T.

On pourrait prévoir en variante que le module d'adaptation 30 détermine la commande à appliquer au sélecteur 32 sur la base de la consigne en fréquence $F_{cons}$ appliquée à l'actionneur de fréquence 6. Par exemple, dans un système où deux consignes en fréquence sont envisagées (fréquence basse et fréquence haute), le module d'adaptation 30 peut commander l'application du multiplicateur $K_1$ lorsque la consigne correspond à la fréquence basse et l'application du multiplicateur $K_2$ ou $K_3$ (selon la température T mesurée) lorsque la consigne correspond à la fréquence haute.

La **figure 4** représente un second mode de réalisation du contrôleur 12 de la figure 2.

Dans ce mode de réalisation, le signal d'erreur E est appliqué à un multiplicateur 44 de coefficient $K_i$ (par exemple fixe). La sortie du multiplicateur 44 est appliquée à un additionneur 46 qui reçoit également en entrée une version retardée (à l'aide d'une mémoire 48) de sa sortie U.

La mémoire 48 est par exemple réalisée sous forme d'un registre ayant une taille prédéterminée (par exemple 8 bits).

Le contrôleur comprend également un module d'adaptation 40 qui permet de forcer la valeur contenue dans la mémoire 48 à une valeur prédéterminée, par exemple lorsque le module d'adaptation 40 détecte un changement de consigne en fréquence $F_{cons}$ vers le bas.

La valeur prédéterminée écrite par le module d'adaptation 40 lors de la détection d'un saut de consigne en fréquence vers le bas peut toutefois être variable, en fonction de la nouvelle consigne en fréquence : le module d'adaptation 40 peut par exemple mémoriser dans une table de correspondance une valeur prédéterminée à écrire dans la mémoire 48 pour chacune d'une pluralité de plages de valeur de consigne en fréquence $F_{cons}$, ou pour un ensemble d'instants de contrôle successifs postérieurement au saut.

Le coefficient $K_i$ du multiplicateur 44, fixe dans l'exemple décrit ici, est par exemple choisi de manière à éviter un dépassement de la consigne lors d'un saut de consigne en fréquence vers le haut (c'est-à-dire que la nouvelle consigne en fréquence est supérieure à la consigne en fréquence antérieure) dans les conditions de fonctionnement envisagées pour le système. On remarque que, lors d'un tel saut de la consigne en fréquence vers le haut, le module d'adaptation 40 n'intervient pas sur la mémoire 48 de sorte que le contrôleur 12 fonctionne de manière à faire converger la fréquence mesurée $F_{mes}$ vers la consigne en fréquence $F_{cons}$ (à partir de la fréquence effective antérieure au saut de fréquence).

Lors d'un tel saut vers le haut (ou saut positif), le signal de commande est donc régi comme suit : $U(k) = K_i.E(k)+U(k-1)$.

En revanche, lorsque le module d'adaptation 40 détecte un saut de consigne en fréquence $F_{cons}$ vers le bas (ou saut négatif, c'est-à-dire que la nouvelle consigne en fréquence est inférieure à la consigne en fréquence antérieure), le module d'adaptation force la valeur de la mémoire 48 à une valeur prédéterminée $U_0$ (qui dépend par exemple comme expliqué ci-dessus de la nouvelle consigne $F_{cons}$).

A l'instant k suivant le saut, le signal de commande U(k) vaut donc : $U(k)=K_i.E(k)+U_0$.

La valeur prédéterminée $U_0$ est choisie, par exemple lors de la conception du système, de sorte que la nouvelle valeur de commande U(k) induise, après application à l'oscillateur 14, une horloge ayant une fréquence égale ou inférieure à la nouvelle consigne $F_{cons}$ selon les paramètres envisagés pour le fonctionnement du système, notamment le coefficient $K_{DCO}$ déjà mentionné de l'oscillateur 14. On note que, dans le cas où le régime établi (correspondant à une situation où la fréquence en sortie a atteint la consigne et ou elle n'évolue plus) a été atteint avant l'application du changement de consigne, la valeur du signal d'erreur E au moment du saut correspond en principe à ce moment à la différence entre la nouvelle consigne et la consigne antérieure.

Naturellement, le comportement temporel de la fréquence effective générée par l'oscillateur 14 du fait de la commande U(k) ne correspond pas précisément au comportement temporel attendu suite à l'application de la nouvelle consigne en fréquence $F_{cons}$, du fait notamment de dérives existant par rapport au fonctionnement théorique, et de la modification de la valeur en mémoire par le biais du module d'adaptation 40. La fréquence effective $F_{appl}$ de l'horloge générée par l'oscillateur 14 convergera toutefois vers la consigne en fréquence $F_{cons}$ du fait de la reprise du fonctionnement en intégrateur du contrôleur 12, par exemple selon la formule $U(k+1)=K_i.E(k+1)+U(k)$ à l'instant (k+1) suivant.

On peut ici préciser à cet égard que le module d'adaptation 40 ne force la valeur de la mémoire 48 à la valeur prédéterminée $U_0$ qu'à l'instant où le saut de consigne $F_{cons}$ vers le bas est détecté. Le reste du temps, la mémoire 48 reçoit la valeur en sortie de l'additionneur 46 comme déjà indiqué.

On comprend que, la valeur prédéterminée $U_0$ étant choisie pour générer en théorie une horloge de fréquence égale à celle de la consigne $F_{cons}$, la fréquence effective $F_{appl}$ générée en pratique converge rapidement vers la consigne $F_{cons}$, le temps de réponse (ou de convergence) de l'actionneur en fréquence variant en conséquence.

Par ailleurs, il est sans importance que la fréquence effectivement générée lors de l'application de la valeur prédéterminée $U_0$ à la mémoire 48 soit supérieure ou inférieure à la consigne $F_{cons}$ envisagée puisque la tension $V_{appl}$ appliquée lors du saut est comme déjà indiqué suffisante pour assurer un fonctionnement sans erreur au circuit électronique 8 même à des fréquences supérieures à la nouvelle consigne en fréquence $F_{cons}$. (Typiquement, la tension appliquée $V_{appl}$ lors du saut est celle précédemment appliquée pour un fonctionnement sûr avec la consigne antérieure, supérieure à la nouvelle consigne dans le cas d'un saut vers le bas étudié ici.)

La **figure 5** représente un troisième mode de réalisation du contrôleur 12 de la figure 2.

Dans ce mode de réalisation, le signal d'erreur E est appliqué à un multiplicateur 54 de coefficient $K_i$ variable sous la commande d'un module d'adaptation 50.

Le signal en sortie du multiplicateur 54 est appliqué à un additionneur 56, qui reçoit également en entrée sa propre sortie U retardée à l'aide d'une mémoire 58.

Comme précédemment, le signal U en sortie de l'additionneur 56 est appliqué à l'oscillateur 14.

On prévoit dans ce mode de réalisation que le module d'adaptation 50 reçoive à la fois la consigne en fréquence $F_{cons}$ et la fréquence mesurée $F_{mes}$.

A la détection d'un saut positif de consigne (c'est-à-dire d'une augmentation de la consigne) par le module d'adaptation 50 (c'est-à-dire une variation de la consigne $F_{cons}$ qu'il reçoit), le module d'adaptation mesure le temps de convergence $t_{conv}$ de la fréquence effective vers sa consigne, c'est-à-dire par exemple le temps mis (à partir de la détection du saut de fréquence) par le signal de fréquence mesurée $F_{mes}$ à atteindre la consigne, à un pourcentage donné près (par exemple à 5 % près).

Le module d'adaptation 50 détermine également si, au cours du temps de convergence, la fréquence mesurée $F_{mes}$ dépasse la nouvelle consigne en fréquence $F_{cons}$.

Une fois le temps de convergence mesuré et l'existence d'un dépassement éventuel déterminée, le module d'adaptation 50 modifie comme suit le coefficient $K_i$ du multiplicateur 54 :

- si le module d'adaptation 50 a constaté l'existence d'un dépassement de la consigne $F_{cons}$, le gain $K_i$ est réduit d'un incrément prédéfini $d_K$;
- si aucun dépassement n'est détecté et que le temps de convergence $t_{conv}$ est inférieur à un premier temps prédéterminé $t_0$ (minimum acceptable), on réduit également le gain d'un incrément prédéfini, par exemple le même incrément $d_K$;
- si aucun dépassement n'est détecté et que le temps de convergence $t_{conv}$ est supérieur à un second temps prédéterminé $t_1$ (maximum acceptable), on augmente le gain $K_i$ d'un incrément prédéfini, par exemple égal à l'incrément

$t_K$ déjà mentionné.

Ainsi, la valeur du gain $K_i$ sera continûment adaptée de manière à éviter un dépassement de la consigne en fréquence $F_{cons}$ et à obtenir un temps de convergence compris entre les temps prédéterminés $t_0$ et $t_1$.

On remarque que la procédure qui vient d'être décrite est appliquée dans le cas d'un saut positif de consigne du fait que l'on souhaite éviter le dépassement de la consigne pour ce type de saut, comme déjà expliqué.

Une procédure similaire pourrait être également appliquée à un saut négatif de consigne afin d'adapter continûment le temps de convergence. La procédure pourrait alors être appliquée après une première modification du gain $K_i$ (afin d'utiliser un gain initial adapté au saut négatif) suivant le mode de réalisation des figures 3A et 3B.

On peut ainsi faire varier le temps de réponse de l'actionneur de fréquence selon le sens de variation de la consigne.

La **figure 6** illustre un autre mode de réalisation de l'invention.

Ce mode de réalisation est basé sur une architecture en boucle fermée comme décrite ci-dessus en référence à la figure 2.

Dans ce mode de réalisation, un module d'adaptation 60 reçoit les valeurs de consigne en fréquence $F_{cons}$ et les valeurs d'erreur E (déjà introduites dans le cadre de la figure 2) et génère sur cette base un gain $K_i$ qu'il transmet au contrôleur 12 afin que ce dernier applique ce gain $K_i$ au signal d'erreur E.

Le présent mode de réalisation est par ailleurs basé sur une modélisation des différents blocs au moyen d'une fonction de transfert en z, comme représenté sur la figure 6.

La fonction de transfert en boucle fermée (c'est-à-dire celle du système de la figure 6 dans son ensemble) s'écrit :

$$\frac{F_{appl}(z)}{F_{cons}(z)} = \frac{K_I K_{DCO}}{1 - \left(1 - K_I K_{DCO} K_S\right) z^{-1}}$$

et

$$\frac{E(z)}{F_{consigne}(z)} = \frac{1}{1 + \dfrac{K_I K_{DCO} K_S}{(z-1)}} = \frac{z-1}{z - \left(1 - K_I K_{DCO} K_S\right)} = \frac{1 - z^{-1}}{1 - \left(1 - K_I K_{DCO} K_S\right) z^{-1}} \ .$$

En notant E(k) et $F_{cons}(k)$ les valeurs du signal d'erreur E et de la consigne en fréquence $F_{cons}$ à l'instant k, on obtient l'expression temporelle suivante pour l'erreur e(k) :

$$E(k) = F_{consigne}(k) - F_{consigne}(k-1) + \left(1 - K_I K_{DCO} K_S\right).E(k-1) \ .$$

On se place par exemple dans le cas où le système a atteint un état d'équilibre à un instant donné (noté ici k = -1), *i.e.* $E(-1) = 0$, et où, à un instant donné (k = 0), on modifie la consigne en échelon, *i.e.* $F_{cons}(0) - F_{cons}(-1) = \Delta F$. On a donc : $E(0) = \Delta F$.

A l'instant suivant (k = 1), on a $F_{cons}(1) - F_{cons}(0) = 0$ (du fait de la forme en échelon de la consigne) et :

$$E(1) = \left(1 - K_I K_{DCO} K_S\right).E(0) = \left(1 - K_I K_{DCO} K_S\right).\Delta F \ .$$

En mesurant $E(1)$ et en tenant compte du fait que $E(0)$ est égal au changement de consigne, le module d'adaptation peut calculer le gain $K_{DCO}$ par:

$$K_{DCO} = \frac{\left(1 - \dfrac{E(1)}{\Delta F}\right)}{K_I K_S} \ .$$

On remarque qu'en régime de fonctionnement établi, le gain $K_I$ est connu du module d'adaptation 60 (puisque généré et commandé par ce module comme décrit ci-après). On peut prévoir par ailleurs une valeur d'initialisation fixe. Le gain $K_S$ du capteur 16 est quant à lui constant et peut donc être considéré comme une valeur fixe du système, mémorisée par exemple au niveau du module d'adaptation 16.

Le gain $K_{DCO}$ de l'oscillateur 14 est donc calculé à partir de la mesure du signal d'entrée E(1) lors d'un saut en fréquence, sans ouvrir la boucle d'asservissement/régulation, et sans avoir à prendre deux points de mesure.

On remarque que ce qui précède s'applique aussi lorsque le changement de consigne n'est pas un échelon, en tenant compte des valeurs particulières successives de la fréquence de consigne.

On peut par ailleurs utiliser plusieurs points de mesure. On est alors amené à minimiser un critère quadratique qui dépend du gain $K_{DCO}$, les autres paramètres $K_I$ et $K_S$ étant considérés connus. On peut par exemple mettre en oeuvre une méthode de programmation non linéaire, comme décrit dans l'ouvrage "Practical methods of optimization", R. Fletcher, 2nd édition, Wiley, ISBN 13: 978 0 471 91547 8. On peut aussi implémenter une méthode de moindres carrés, non optimale dans ce cas puisque le problème n'est pas linéaire en $K_{DCO}$, mais dont le résultat sera tout à fait satisfaisant si on fait l'hypothèse que le niveau de bruit est faible.

Quelle que soit la technique de détermination utilisée, il est possible de déterminer, grâce à la connaissance du gain de l'oscillateur 14, le gain $K_I$ à utiliser lors du saut suivant afin d'obtenir une allure particulière pour la réponse comme suit.

En considérant les équations rappelées ci-dessus, on constate que le pôle $\alpha$ du système en boucle fermée s'écrit : $\alpha = 1 - K_I K_{DCO} K_S$. Or ce pôle est directement lié à l'allure de la réponse souhaitée, c'est-à-dire au temps de réponse, par exemple à 5%, et à l'allure transitoire de la réponse temporelle (voir par exemple à ce sujet l'ouvrage "Analyse des Systèmes linéaires", sous la direction de Ph. de Larminat, collection I2C, Hermes, ISBN 2-7462-0491-6).

On propose d'utiliser des valeurs prédéterminées pour le pôle $\alpha$, caractéristiques de l'allure de la réponse, ici une valeur prédéterminée $\alpha_p$ pour les sauts positifs de consigne et une valeur prédéterminée $\alpha_N$ pour les sauts négatifs de consigne (la différenciation entre saut positif et sauf négatif étant utile pour les raisons déjà exposées ci-dessus).

Ainsi, lorsque le module d'adaptation 60 détecte un saut positif de consigne $F_{cons}$, il commande au contrôleur 12 l'utilisation d'un gain $K_I = \dfrac{1 - \alpha_P}{K_{DCO} K_S}$ ; en revanche, lorsque le module d'adaptation 60 détecte un saut négatif de consigne $F_{cons}$, il commande au contrôleur 12 l'utilisation d'un gain $K_I = \dfrac{1 - \alpha_N}{K_{DCO} K_S}$. On remarque que, dans les deux cas, la valeur du gain $K_{DCO}$ utilisée est celle déterminée comme indiqué ci-dessus par mesure lors du saut précédent (on peut naturellement utiliser une valeur par défaut si aucune mesure n'a été réalisée au préalable, par exemple lors de l'initialisation du processus).

Les modes de réalisation qui précèdent ne sont que des exemples possibles de mise en oeuvre de l'invention, qui ne s'y limite pas.

Par exemple, la détermination du gain $K_{DCO}$ de l'oscillateur par mesure, présentée en référence à la figure 6, pourrait être utilisée dans le cadre du mode de réalisation de la figure 4, ce qui permettrait de faire varier la valeur $U_0$ en fonction du gain $K_{DCO}$ déterminé (la valeur $U_0$ choisie dépendant notamment du gain $K_{DCO}$ de l'oscillateur comme indiqué ci-dessus).

**Revendications**

**1.** Dispositif d'alimentation d'un circuit électronique numérique synchrone cadencé par un signal d'horloge (H) ayant une fréquence d'horloge ($F_{appl}$), comprenant :

- un actionneur de fréquence (6) comprenant un contrôleur (12), l'actionneur de fréquence (6) étant conçu pour générer le signal d'horloge (H) en fonction d'une consigne de fréquence ($F_{cons}$) selon un mécanisme de régulation, le contrôleur (12) recevant un signal d'erreur (E) obtenu par différence entre la consigne de fréquence ($F_{cons}$) et une fréquence mesurée (Fmes) du signal d'horloge (H), le contrôleur étant conçu pour appliquer un gain au signal d'erreur (E), l'actionneur de fréquence (6) incluant un oscillateur (14) commandé par un signal de commande (U) généré par le contrôleur (12) sur la base dudit signal d'erreur (E);
- un module de commande (2) conçu pour appliquer sélectivement à l'actionneur de fréquence (6) une première consigne de fréquence ou une seconde consigne de fréquence supérieure à la première consigne ;

**caractérisé par** :

- un module d'adaptation (30 ; 40 ; 50 ; 60) conçu pour modifier le mécanisme de régulation en fonction de la consigne appliquée en contrôlant le gain appliqué par le contrôleur, de manière que lorsque la consigne de fréquence augmente, le gain appliqué par le contrôleur diminue de sorte que le temps de réponse de l'actionneur de fréquence (6) augmente et

lorsque la consigne de fréquence diminue, le gain appliqué par le contrôleur augmente de sorte que le temps de réponse de l'actionneur de fréquence (6) diminue.

2. Dispositif d'alimentation selon la revendication 1, dans lequel le module d'adaptation (60) est conçu pour commander le gain ($K_I$) appliqué par le contrôleur (12) en fonction d'un gain ($K_{DCO}$) de l'oscillateur (14).

3. Dispositif d'alimentation selon la revendication 1, dans lequel un sélecteur (32) commandé par le module d'adaptation (30) est conçu pour appliquer sélectivement le signal d'erreur (E) à un multiplicateur (34) parmi une pluralité de multiplicateurs.

4. Dispositif d'alimentation selon la revendication 1, dans lequel le contrôleur (12) comprend une mémoire (48) conçue pour mémoriser une valeur de commande (U) et le module d'adaptation (40) est conçu pour forcer la mémoire (48) à une valeur prédéterminée ($U_0$) à détection d'un saut de consigne.

5. Dispositif selon l'une des revendications 1 à 4, comprenant en outre un actionneur de tension (4) conçu pour générer une tension ($V_{appl}$) en fonction d'une consigne en tension ($V_{cons}$), adaptée à la consigne de fréquence ($F_{cons}$), lors de l'application de la consigne de fréquence à l'actionneur de fréquence (6).


**Patentansprüche**

1. Vorrichtung zum Versorgen einer synchronen, digitalen elektronischen Schaltung, die durch ein Taktsignal (H) mit einer Taktfrequenz ($F_{appl}$) getaktet ist, enthaltend:

- ein Frequenzstellglied (6) mit einer Steuerung (12),
wobei das Frequenzstellglied (6) dazu ausgelegt ist, das Taktsignal (H) in Abhängigkeit von einem Frequenzsollwert ($F_{cons}$) gemäß einem Regelmechanismus zu erzeugen, wobei die Steuerung (12) ein Fehlersignal (E) empfängt, das durch die Differenz zwischen dem Frequenzsollwert ($F_{cons}$) und einer gemessenen Frequenz ($F_{mes}$) des Taktsignals (H) erhalten wird, wobei die Steuerung dazu ausgelegt ist, auf das Fehlersignal (E) eine Verstärkung anzuwenden, wobei das Frequenzstellglied (6) einen Oszillator (14) einschließt, der von einem von der Steuerung (12) basierend auf dem Fehlersignal (E) erzeugten Steuersignal (U) gesteuert wird;
- ein Steuermodul (2), das dazu ausgelegt ist, selektiv einen ersten Frequenzsollwert oder einen zweiten Frequenzsollwert, der größer als der erste Sollwert ist, auf das Frequenzstellglied (6) anzuwenden, **gekennzeichnet durch**
- ein Anpassungsmodul (30; 40; 50; 60), das dazu ausgelegt ist, den Regelmechanismus in Abhängigkeit von dem Sollwert zu modifizieren, der durch Steuern der von der Steuerung angewendeten Verstärkung vorgegeben wird, so dass mit zunehmendem Frequenzsollwert die von der Steuerung angewendete Verstärkung abnimmt, so dass die Ansprechzeit des Frequenzstellglieds (6) zunimmt und mit abnehmendem Frequenzsollwert die von der Steuerung angewendete Verstärkung zunimmt, so dass die Ansprechzeit des Frequenzstellglieds (6) abnimmt.

2. Versorgungsvorrichtung nach Anspruch 1, wobei das Anpassungsmodul (60) dazu ausgelegt ist, die von der Steuerung (12) angewendete Verstärkung ($K_I$) in Abhängigkeit von einer Verstärkung ($K_{DCO}$) des Oszillators (14) zu steuern.

3. Versorgungsvorrichtung nach Anspruch 1, wobei ein über das Anpassungsmodul (30) gesteuertes Auswahlglied (32) dazu ausgelegt ist, das Fehlersignal (E) selektiv an einen Multiplizierer (34) aus einer Vielzahl von Multiplizierern (34) anzulegen.

4. Versorgungsvorrichtung nach Anspruch 1, wobei die Steuerung (12) einen Speicher (48) enthält, der dazu ausgelegt ist, einen Steuerwert (U) zu speichern, und das Anpassungsmodul (40) dazu ausgelegt ist, den Speicher (48) auf einen vorbestimmten Wert (Uo) festzulegen, wenn ein Sollwertsprung erkannt wird.

5. Versorgungsvorrichtung nach einem der Ansprüche 1 bis 4, ferner enthaltend ein Spannungsstellglied (4), das dazu

**EP 2 862 036 B1**

ausgelegt ist, eine Spannung ($V_{appl}$) in Abhängigkeit von einem Spannungssollwert ($V_{cons}$) zu erzeugen, der an den Frequenzsollwert ($F_{cons}$) angepasst ist, wenn der Frequenzsollwert auf das Frequenzstellglied (6) angewendet wird.

**Claims**

1. A supply device for supplying a synchronous digital electronic circuit for which timing is provided by a clock signal (H) having a clock frequency ($F_{appl}$), comprising:

   - a frequency actuator (6) comprising a controller (12), the frequency actuator (6) being designed to generate the clock signal (H) according to a frequency setting ($F_{cons}$) based on a regulation mechanism, the controller (12) receiving an error signal (E) obtained by difference between the frequency setting ($F_{cons}$) and a measured frequency ($F_{mes}$) of the clock signal (H), the controller being designed to apply a gain to the error signal (E), the frequency actuator (6) including an oscillator (14) controlled by a control signal (U) generated by the controller (12) on the basis of said error signal (E);
   - a control module (2) designed to selectively apply to the frequency actuator (6) a first frequency setting or a second frequency setting higher than the first setting;

   **characterized by**:

   - an adaptation module (30 ; 40 ; 50 ; 60) designed to modify the regulation mechanism according to the applied setting by controlling the gain applied by the controller such that when the frequency setting increases, the gain applied by the controller decreases such that the response time of the frequency actuator (6) increases and when the frequency setting decreases, the gain applied by the controller increases such that the response time of the frequency actuator (6) decreases.

2. A supply device according to claim 1, wherein the adaptation module (60) is designed to control the gain ($K_I$) applied by the controller (12) according to a gain ($K_{DCO}$) of the oscillator (14).

3. A supply device according to claim 1, wherein a selector (32) controlled by the adaptation module (30) is designed to selectively apply the error signal (E) to a multiplier (34) from among a plurality of multipliers.

4. A supply device according to claim 1, wherein the controller (12) comprises a memory (48) designed to store a control value (U) and the adaptation module (40) is designed to force the memory (48) to a predetermined value (Uo) on detection of a setting jump.

5. A device according to one of claims 1 to 4, further comprising a voltage actuator (4) designed to generate a voltage ($V_{appl}$) according to a voltage setting ($V_{cons}$), adapted to the frequency setting ($F_{cons}$), on application of the frequency setting to the frequency actuator (6).

## Fig. 1

$V_{cons}$

4

$V_{appl}$

8

$F_{cons}$

6

$H (F_{appl})$

2

1

## Fig. 2

10

12

14

$F_{cons}$

E

U

$H (F_{appl})$

$F_{mes}$

6

16

## Fig. 3A

30

32

34

36

E

$K_1$

$K_2$

$K_3$

U

38

Fig. 3B

Fig. 4

Fig. 5

$F_{appl}$

Fig. 6

**EP 2 862 036 B1**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 5257294 A
- EP 0944172 A
- US 6236278 B
- WO 2005060103 A

**Littérature non-brevet citée dans la description**

- **S. MIERMONT ; P. VIVET ; M. RENAUDIN.** A power supply selector for energy- and area-efficient local dynamic voltage scaling. *Lecture Notes in Computer Science,* 2007, vol. 4644, 556-565
- **R. FLETCHER.** Practical methods of optimization. Wiley
- **PH. DE LARMINAT.** Analyse des Systèmes linéaires. Hermes